**Europäisches Patentamt**

**European Patent Office**

**Office européen des brevets**

(19)

(11) Veröffentlichungsnummer: **0 048 863**
**B1**

(12) **EUROPÄISCHE PATENTSCHRIFT**

(45) Veröffentlichungstag der Patentschrift:
20.03.85

(51) Int. Cl.⁴: **G 01 R 31/26**, G 01 R 29/14

(21) Anmeldenummer: 81107152.1

(22) Anmeldetag: **10.09.81**

(54) Verfahren und Anordnung zur quantitativen Potentialmessung an Oberflächenwellenfiltern.

(30) Priorität: 29.09.80 DE 3036713

(43) Veröffentlichungstag der Anmeldung:
07.04.82 Patentblatt 82/14

(45) Bekanntmachung des Hinweises auf die Patenterteilung:
20.03.85 Patentblatt 85/12

(84) Benannte Vertragsstaaten:
DE FR GB NL

(56) Entgegenhaltungen:
DE - A - 2 805 673
DE - B - 1 943 140

SCANNING ELECTRON MICROSCOPY, 1980, Chicago,
H.P. FEUERBAUM et al. "Visualization of traveling
surface acoustic waves using a scanning electron
microscope", Seiten 503-508

(73) Patentinhaber: **Siemens Aktiengesellschaft, Berlin und
München Wittelsbacherplatz 2, D-8000 München 2 (DE)**

(72) Erfinder: **Feuerbaum, Hans-Peter, Dipl.-Phys.,
Tucholskystrasse 22, D-8000 München 83 (DE)**
Erfinder: **Tobolka, Gerald, Dr. phil., Werinherstrasse 103,
D-8000 München 90 (DE)**

ACTORUM AG

### Beschreibung

Die Erfindung betrifft ein Verfahren nach dem Oberbegriff des Anspruchs 1 und eine Anordnung nach dem Oberbegriff des Anspruchs 3 zur Potentialmessung an Oberflächenwellenfiltern.

Elektronenstrahlmessgeräte erlauben über die qualitative Messung des Potentialkontrastes eine Abbildung der Potentialverteilung in Oberflächenwellenfiltern, wie es in Scanning Electron Microscopy, 1980, Chicago, Seiten 503–508 von H.P. Feuerbaum et al. beschrieben worden ist. Elektronenstrahl-Messgeräte ermöglichen damit eine qualitative Aussage über das lokale Potential in Oberflächenwellenfiltern. Für die Messung von bestimmten Filtercharakteristiken der Oberflächenwellenfilter besteht jedoch auch die Forderung nach einer lokalen quantitativen Potentialmessung. Zweck der Erfindung ist die quantitative Potentialmessung an Oberflächenwellenfiltern.

Bisher wurden solche Messungen mit einer mechanischen Messspitze durch kapazitive Kopplung durchgeführt. Eine Potentialmessung mit Hilfe von Sekundärelektronen, wie sie bei Halbleiterschaltungen angewandt wird und wie sie beispielsweise aus der deutschen Auslegeschrift DE-B2- 1 943 140 bekannt ist, versagt bei der Messung an Oberflächenwellenfiltern wegen der dabei auftretenden Aufladung.

Der Erfindung liegt die Aufgabe zugrunde, ein Verfahren und eine Anordnung der eingangs genannten Art zur quantitativen Potentialmessung an Oberflächenwellenfiltern mit einer hohen zeitlichen und räumlichen Auflösung anzugeben.

Erfindungsgemäss wird diese Aufgabe durch ein Verfahren nach dem Anspruch 1 und durch eine Anordnung nach dem Anspruch 3 gelöst.

Erfindungsgemäss ist eine Anordnung zur quantitativen Potentialmessung an Oberflächenwellenfiltern beispielsweise so ausgebildet, dass ein Generator einen Modulator und einen Pulsgenerator mit einer Wechselspannung beaufschlagt, wobei der Pulsgenerator ein schnelles Strahlaustastsystem eines stroboskopischen Elektronenstrahl-Messgerätes ansteuert, wobei die Primärelektronen beim Auftreffen auf das zu untersuchende Oberflächenwellenfilter, das vom Modulator über einen Leistungsverstärker angetrieben wird, Sekundärelektronen auslösen, wobei das entstehende Sekundärelektronen-Wechselstromsignal zuerst einen Vorverstärker und dann eine Verstärkereinrichtung passiert, welche die Abweichung der Amplitude $I_{AC}$ des Sekundärelektronen-Wechselstromsignals vom Sollwert verstärkt und über den Modulator die Amplitude des Leistungsverstärkers steuert.

Vorteilhafterweise wird zur Messung des Sekundärelektronen-Wechselstromsignals und zum Vergleich dieses Signals mit dem Sollwert und zur Verstärkung der Abweichung dieses Signals vom Sollwert ein Lock-in-Verstärker verwendet sowie ein Operationsverstärker.

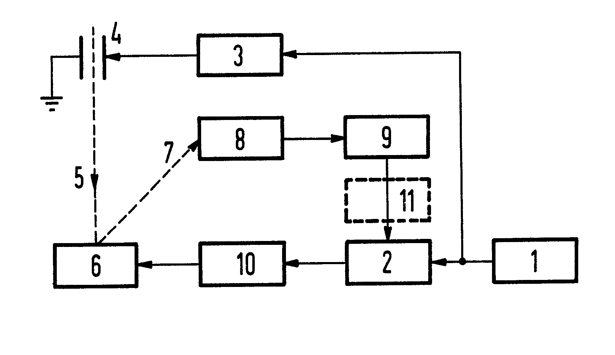

Die Erfindung ist in der Zeichnung dargestellt und wird im folgenden näher erläutert.

Die Figur zeigt eine Anordnung zur quantitativen Potentialmessung an Oberflächenwellenfiltern.

Die Messung erfolgt stroboskopisch nach dem Sampling-Prinzip. Ein Verfahren und eine Anordnung zur qualitativen Potentialmessung an Oberflächenwellenfiltern mit einem Elektronenstrahl-Messgerät ist von G. Eberharter und G.P. Feuerbaum und G. Tobolka in der eingangs erwähnten Druckschrift SEM Inc. AMF O'Hare (Chicago) 1980, Vol. I, Seiten 503–508 beschrieben.

Erfindungsgemäss ist diese Anordnung so zu modifizieren, dass ein Generator 1 einen Modulator 2 und einen Pulsgenerator 3 mit einer hochfrequenten Wechselspannung beaufschlagt, wobei der Pulsgenerator 3 ein schnelles Strahlaustastsystem 4 des aus der angegebenen Veröffentlichung bekannten modifizierten Elektronenstrahlgerätes ansteuert, wobei die Primärelektronen 5 beim Auftreffen auf das zu untersuchende Oberflächenwellenfilter 6, das vom Modulator 2 über einen Leistungsverstärker 10 angetrieben wird, Sekundärelektronen 7 auslösen, wobei das entstehende Sekundärelektronen-Signal in dem aus der angegebenen Veröffentlichung (Scanning Electron Microscopy) bekannten Vorverstärker 8 verstärkt wird, wobei das Sekundärelektronen-Wechselstromsignal anschliessend im Lock-in-Verstärker 9 gemessen und mit einem Sollwert verglichen wird.

Die Abweichung des Sekundärelektronen-Wechselstromsignals vom Sollwert wird im Lock-in-Verstärker 9 verstärkt und steuert über den Modulator 2 die Verstärkung des Leistungsverstärkers 10, der das Oberflächenwellenfilter 6 treibt. Die Abweichung des Sekundärelektronen-Wechselstromsignals vom Sollwert ist damit ein Mass für die Oberflächendämpfung des zu untersuchenden Oberflächenwellenfilters 6.

Die Messung erfolgt nach dem Sampling-Prinzip, wobei die gesamte Periode des lokal zu messenden Wechselspannungs-Signalverlaufs in kurzer Zeit ($< 10^{-2}$ s) von dem gepulsten Elektronenstrahl abgetastet wird.

Prinzipiell entsteht der Potentialkontrast auf Oberflächenwellenfiltern durch lokale Potentialdifferenzen. Wenn ein Gebiet das positive Potential $U_P$ aufweist, dann wird oberhalb dieses Gebiets ein Gegenfeld aufgebaut. Aus solchen Gebieten mit positivem Potential werden daher weniger Sekundärelektronen 7 (SE) emittiert als aus Gebieten mit nicht positivem Potential. Der Sekundärelektronen-Strom 7 ergibt sich aus dem Integral über die Sekundärelektronen-Energieverteilung $N(E)$.

$$I = I_{PE} \int_{eU_B}^{50\ eV} N(E)dE.$$

Mit $I_{PE}$ ist dabei der Strom der Primärelektronen 5 bezeichnet, welcher bei der Messung konstant gehalten wird. $U_B = f(U_P)$ ist die Höhe der Potentialbarriere am lokalen Messpunkt. Sekundärelektronen mit einer Energie, die kleiner ist als $eU_B$, können den Bereich des Oberflächenwellenfilters 6 nicht verlassen. Sekundärelektronen, deren Energie grösser ist als 50 eV, tragen zum Sekundärelektronen-Strom 7 kaum noch bei.

Liegt am lokalen Messpunkt eine Wechselspannung mit der Amplitude $U_P$ an, so ergibt sich ein lokales Sekundärelektronen-Wechselstromsignal mit der Amplitude $I_{AC}$.

$$I_{AC} = I_{PE} \int_0^{ef(U_P)} N(E)dE.$$

Dem Sekundärelektronen-Signal 7, welches im Vorverstärker 8, das eine Scintillator-Fotomultiplier-Kombination darstellt, verstärkt wird, ist dieses lokale Sekundärelektronen-Wechselstromsignal mit der Amplitude $I_{AC}$ überlagert. Dieses lokal gemessene Sekundärelektronen-Wechselstromsignal wird im Lock-in-Verstärker 9 gemessen und mit einem Sollwert verglichen. Die Abweichung von diesem Sollwert wird im Lock-in-Verstärker 9 noch verstärkt und steuert über den Modulator 2 die Verstärkung des Leistungsverstärkers 10, der das Oberflächenwellenfilter treibt.

In der angegebenen Regelschaltung, die im wesentlichen aus dem Lock-in-Verstärker 9, dem Modulator 2 und dem Leistungsverstärker 10 besteht, wird dieser Wechselstrom mit dieser Wechselstromamplitude $I_{AC}$ bei allen lokalen Messungen über die gesamte Probe konstant gehalten. Da diese Wechselstromamplitude $I_{AC}$ bei allen lokalen Messungen über das gesamte Oberflächenwellenfilter konstant ist, gilt:

$$\int_0^{ef(U_P)} N(E)dE = const.$$

Dass die Wechselstromamplitude $I_{AC}$ bei allen lokalen Messungen über die gesamte Probe hinweg konstant ist, wird dadurch erreicht, dass die am Eingangswandler des Oberflächenwellenfilters angelegte Spannung $U_{E_i} = \alpha_i U_P$ geregelt wird. Der Faktor $\alpha_i$ gibt die lokale Dämpfung der Welle im Filter am lokalen Messpunkt mit dem Index i wieder. Das eigentliche Messergebnis besteht also darin, dass der Dämpfungsfaktor $\alpha_i$ als Funktion von verschiedenen interessierenden Messpunkten mit dem Index i auf den Oberflächen des Oberflächenwellenfilters gewonnen wird.

Da der Wert des gerade angegebenen Integrals über alle lokalen Messpunkte hinweg konstant ist, und da auch die Sekundärelektronen-Energieverteilung N(E) über alle lokalen Messpunkte der Probe hinweg konstant ist, müssen auch die Grenzen des Integrals konstant sein. Da also auch insbesondere dann die obere Grenze dieses Integrals konstant sein muss über alle lokalen Messpunkte der Probe hinweg, ist die Höhe der Potentialbarriere am lokalen Messpunkt $f(U_P)$ über alle lokalen Messpunkte hinweg konstant. Daraus ergibt sich jedoch, dass der Quotient aus der am Eingangswandler in Abhängigkeit vom lokalen Messpunkt angelegten Spannung $U_{E_i}$ und der lokalen Dämpfung der Welle im Filter am lokalen Messpunkt $\alpha_i$ über alle lokalen Messpunkte der Probe hinweg konstant ist:

$$f(U_P) = const$$
$$\frac{U_{E_i}}{\alpha_i} = const$$

Damit kann bei der erfindungsgemässen Messung an z.B. zwei verschiedenen lokalen Messpunkten auf der Probe aus dem Verhältnis der Eingangsspannungen

$$\frac{U_{E_1}}{U_{E_2}}$$

auf die Dämpfung

$$\frac{\alpha_1}{\alpha_2}$$

zwischen diesen Punkten geschlossen werden. Die Dämpfung als Funktion der Messpunkte und als Funktion der Frequenz gibt bestimmte Filtercharakteristiken wieder.

Zweckmässig ist es, das vom Lock-in-Verstärker 9 abgegebene Signal mit einem Operationsverstärker 11 zu verstärken.

Als Lock-in-Verstärker 9 wurde das Gerät Dynotrac 391 A der Fa. Ithaco verwendet.

**Patentansprüche**

1. Verfahren zur Bestimmung der Filtercharakteristik eines Oberflächenwellenfilters, bei dem an den Eingangswandler des Oberflächenwellenfilters (6) eine Wechselspannung mit der Amplitude $U_{E_i}$ angelegt wird, bei dem mit Hilfe einer Elektronenstrahl-Messsonde stroboskopisch nach dem Sampling-Prinzip jeweils an verschiedenen Messpunkten der Oberfläche des Oberflächenwellenfilters die gesamte Periode des zu messenden Wechselspannungs-Signalverlaufs auf der Oberfläche des Oberflächenwellenfilters (6) von einem gepulsten Elektronenstrahl (5) abgetastet wird, und bei dem das dabei entstehende Sekundärelektronen-Signal (7) gemessen wird, dadurch gekennzeichnet, dass der im Sekundärelektronen-Signal (7) enthaltene Wechselstromsignalanteil mit der Amplitude $I_{AC}$ gemessen und mit einem Sollwert verglichen wird, der für alle Messpunkte gleich ist, dass die Abweichung vom Sollwert verstärkt wird und dass mittels dieser verstärkten Abweichung die Amplitude $U_{E_i}$ der dem Eingangswandler zugeführten Wechselspannung so gesteuert wird, dass die Amplitude $I_{AC}$ des Wechselstromsignalanteils konstant bleibt, wobei durch Vergleich von sich für verschiedene Messpunkte ergebenden Amplituden $U_{E_i}$ der am Eingangswandler anliegenden Wechselspannung auf den Oberflächendämpfungsverlauf des Oberflächenwellenfilters (6) und damit als Funktion der Frequenz der Wechselspannung auf bestimmte Filtercharakteristiken geschlossen werden kann.

2. Verfahren nach Anspruch 1, dadurch gekennzeichnet, dass der Wechselstromsignalanteil mit der Amplitude $I_{AC}$ mit einem Lock-in-Verstärker (9) gemessen und mit dem Sollwert verglichen wird.

3. Anordnung zur Durchführung des Verfahrens nach Anspruch 1 oder 2 mit
- einer ein Strahlaustastsystem (4) aufweisenden Elektronenstrahl-Messsonde zur Beaufschlagung des Oberflächenwellenfilters (6) mit einem gepulsten Primärelektronenstrahl (5),
- einem Pulsgenerator (3) zur Steuerung des Strahlaustastsystems (4),
- einer Detektoranordnung (8) zur Erfassung der vom Primärelektronenstrahl jeweils an unterschiedlichen Messpunkten ausgelösten Sekundärelektronen (7) und zur Erzeugung eines elektrischen Ausgangssignals,
- einem an den Eingangswandler des Oberflächenwellenfilters (6) angeschlossenen Generator (1) zur Beaufschlagung des Eingangswandlers mit einem elektrischen Wechselspannungssignal der Amplitude $U_{Ei}$, gekennzeichnet durch
- eine Einrichtung (9) zur Detektion der Amplitude $I_{AC}$ des im elektrischen Ausgangssignal enthaltenen Wechselsignals,
- eine Einrichtung (9) zum Vergleich der Amplitude $I_{AC}$ mit einem vorgegebenen Sollwert, und
- eine Einrichtung (2, 10) zur Steuerung der Amplitude $U_{Ei}$ des Wechselspannungssignals in Abhängigkeit von der Abweichung der Amplitude $I_{AC}$ vom Sollwert, derart, dass die Amplitude $I_{AC}$ konstant gehalten wird.

**Claims**

1. A method for determining the filter characteristic of a surface wave filter wherein an a.c. voltage of amplitude $U_{Ei}$ is applied to the input transducer of the surface wave filter (6), wherein an electron beam measuring probe helps, stroboscopically in accordance with the sampling principle to sample at various measurement points of the surface of the surface wave filter the entire period of the a.c. voltage signal waveform to be measured, the sampling on the surface of the surface wave filter (6) being effected by a pulsed electron beam (5), and wherein the secondary electron signal (7) thus formed is measured, characterised in that the a.c. current signal component of amplitude $I_{AC}$, contained in the secondary electron signal (7), is measured and compared with a theoretical value which is identical for all the measurement points, that any deviation from the theoretical value is amplified, and that by means of this amplified deviation the amplitude $U_{Ei}$ of the a.c. voltage supplied to the input transducer is controlled such that the amplitude $I_{AC}$ of the a.c. current signal component remains constant, and by comparing amplitudes $U_{Ei}$ of the a.c. voltage connected to the input transducer which occur for various measurement points it is possible to draw conclusions concerning the surface attenuation curve of the surface wave filter (6) and thus concerning specific filter characteristics as a function of the frequency of the a.c. voltage.

2. A method as claimed in Claim 1, characterised in that the a.c. current signal component with the amplitude $I_{AC}$ is measured with a lock-in amplifier (9) and is compared with the theoretical value.

3. An arrangement for implementing the method claimed in Claim 1 or 2, with:
- an electron beam measuring probe provided with a beam blanking system (4) to supply the surface wave filter (6) with a pulsed primary electron beam (5);
- a pulse generator (3) to control the beam blanking system (4);
- a detector arrangement (8) to detect the secondary electrons (7) each triggered by the primary electron beam at different measurement points and to produce an electrical output signal;
- a generator (1) which is connected to the input transducer of the surface wave filter (6) to supply the input transducer with an electrical a.c. voltage signal of the amplitude $U_{Ei}$; characterised by:
- a device (9) to detect the amplitude $I_{AC}$ of the a.c. signal contained in the electrical output signal;
- a device (9) to compare the amplitude $I_{AC}$ with a given theoretical value; and
- a device (2, 10) which serves to control the amplitude $U_{Ei}$ of the a.c. voltage signal in dependence upon the deviation of the amplitude $I_{AC}$ from the theoretical value, such that the amplitude $I_{AC}$ maintained constant.

**Revendications**

1. Procédé pour déterminer la caractéristique de transmission d'un filtre à ondes de surface, dans lequel on applique au transducteur entrée du filtre à ondes de surface (6) une tension alternative d'amplitude $U_{Ei}$ dans lequel, à l'aide d'un sonde de mesure à rayon électronique, on procède, par voie stroboscopique et selon le principe de l'échantillonnage, en différents points de mesure de la surface du filtre à ondes de surface, au balayage, à l'aide d'un rayon électronique pulsé (5), de la totalité de la période d'allure du signal de tension alternative à mesurer sur la surface du filtre à ondes de surface (6), et dans lequel on mesure le signal (7) donné par les électrons secondaires et qui se forment, caractérisé par le fait que la composante du signal du courant alternatif d'amplitude $I_{AC}$, qui est contenue dans le signal (7) des électrons secondaires, est mesurée et est comparée avec une valeur de consigne qui est la même pour tous les points de mesure, que l'écart par rapport à la valeur de consigne est amplifié, et qu'à l'aide de cet écart amplifié on commande l'amplitude $U_{Ei}$ de la tension alternative appliquée au transducteur d'entrée, de manière que l'amplitude $I_{AC}$ de la composante du signal du courant alternatif reste constante, la comparaison entre les amplitudes $U_{Ei}$, qui en résultent en différents points de mesure, de la tension alternative appliquée au transducteur d'entrée permettent de tirer des conclusions quant à l'allure de l'atténuation superficielle du filtre à ondes de surface (6), et, par voie de conséquence, et en tant que fonction de la fréquence de la tension alternative, quant à certaines caractéristiques du filtre.

2. Procédé selon la revendication 1, caractérisé par le fait que la composante du signal du courant alternatif d'amplitude $I_{AC}$ est mesurée avec un amplificateur cohérent (9) et est comparée à la valeur de consigne.

3. Dispositif pour la mise en œuvre du procédé selon la revendication 1 ou 2, comportant

- une sonde de mesure à rayon électronique comportant un système de balayage du rayon (4), en vue de charger le filtre à ondes de surface (6) avec un rayon pulsé d'électrons primaires (5),
- un générateur d'impulsions (3) pour commander le système de balayage du rayon (4),
- un dispositif détecteur (8) pour saisir les électrons secondaires (7) libérés par le rayon d'électrons primaires en différents points de mesure, et pour produire un signal électrique de sortie,
- un générateur (1) qui est relié au transducteur d'entrée du filtre à ondes de surface (6) et servant à charger le transducteur d'entrée avec un signal électrique de tension alternative d'amplitude $U_{E_i}$, caractérisé par
- un dispositif (9) pour détecter l'amplitude $I_{AC}$ du signal alternatif qui est contenu dans le signal électrique de sortie,
- un dispositif (9) pour comparer l'amplitude $I_{AC}$ avec une valeur de consigne prédéterminée, et
- un dispositif (2, 10) pour commander l'amplitude $U_{E_i}$ du signal de tension alternative, en fonction de l'écart de l'amplitude $I_{AC}$ par rapport à la valeur de consigne, de manière que l'amplitude $I_{AC}$ soit maintenue à une valeur constante.